# FASCICULE DE BREVET EUROPEEN

(11) **EP 2 789 976 B1**
(45) Date de publication et mention de la délivrance du brevet: **13.01.2016**
(21) Numéro de dépôt: 13163181.4
(22) Date de dépôt: 10.04.2013
(51) Int. Cl.: G01C 19/5712, G01C 19/5776

(54) **Circuit électronique d'entraînement d'un dispositif à résonateur du type MEMS, et procédé pour sa mise en action**
Elektronischer Antriebsschaltkreis einer Vorrichtung mit Resonator vom Typ MEMS, und Verfahren zu seiner Ingangsetzung
Electronic circuit for driving a device with MEMS resonator, and method for activating same

(43) Date de publication de la demande: 15.10.2014
(73) Titulaire: EM Microelectronic-Marin SA, 2074 Marin (CH)
(72) Inventeur: Entringer, Christophe, 1426 Corcelles-près-Concise (CH); Deschildre, Alexandre, 2074 Marin (CH)
(74) Mandataire: Giraud, Eric

(56) Documents cités:
- US-A1- 2010 149 721
- US-A1- 2011 005 315
- US-A1- 2011 197 675

## Description

### DOMAINE TECHNIQUE

La présente invention concerne un circuit électronique d'entraînement d'un dispositif à résonateur du type MEMS, et en particulier pour un gyroscope du type MEMS à haut facteur de qualité.

La présente invention concerne également le procédé de mise en action du circuit électronique d'entraînement du dispositif à résonateur du type MEMS.

### ARRIERE-PLAN TECHNOLOGIQUE

De manière conventionnelle, un circuit électronique relié à un résonateur d'un dispositif à résonateur du type MEMS peut également être utilisé pour effectuer une mesure d'une vitesse angulaire. Il peut être prévu de mesurer une vitesse angulaire selon un, deux ou trois axes par exemple avec un gyroscope du type MEMS. Le gyroscope comprend généralement au moins une masse maintenue par une structure sous forme de ressort et susceptible d'être mise en oscillation électriquement à une fréquence déterminée par la constante du ressort avec un facteur d'amortissement défini de la masse. Une vitesse angulaire peut être déterminée sur la base d'une vitesse d'oscillation de la masse et de la force générée, qui est perpendiculaire à la vitesse angulaire et au déplacement en oscillation de la masse.

Pour ce faire, il existe des circuits électroniques d'entraînement, qui utilisent préférentiellement une oscillation dans une boucle à verrouillage de phase pour l'entraînement de l'oscillation selon au moins un axe de déplacement du résonateur du type MEMS comme décrit notamment dans les demandes de brevet EP 2 259 019 A1 et EP 2 336 717 A1. L'utilisation d'une boucle à verrouillage de phase pour l'entretien de l'oscillation de la masse du résonateur ne permet pas de réduire la consommation générale du système pour l'asservissement de la phase et de l'amplitude d'oscillation, ce qui constitue un inconvénient. Il doit également être tenu compte d'une tension d'alimentation relativement élevée pour maintenir en oscillation ladite masse, et ne permet pas de réduire le temps de démarrage du circuit d'entraînement du gyroscope, ce qui constituent d'autres inconvénients.

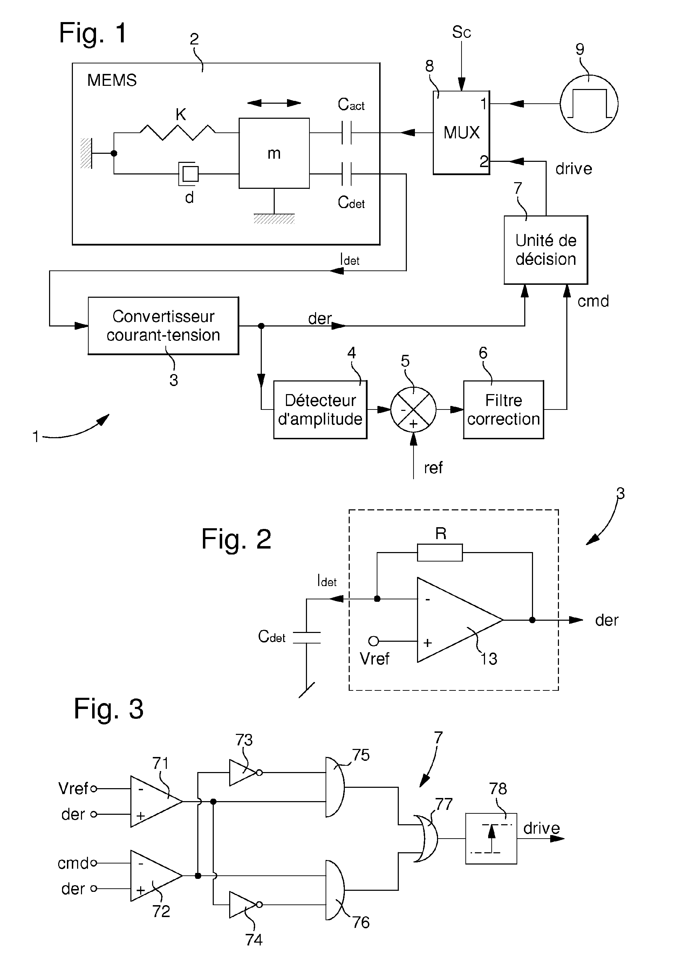

On peut citer aussi le circuit électronique d'entraînement d'un résonateur MEMS d'un gyroscope selon un, deux ou trois axes, qui est décrit dans la thèse intitulée "System and circuit design for a capacitive MEMS gyroscope" rédigée par Mikko Saukoski de l'université d'Helsinki dans la faculté d'électronique, communication et automatisation, dans le département des micro- et nanosciences en 2008 (ISBN9789512292974). Comme précédemment, il est utilisé une boucle à verrouillage de phase pour le maintien de l'oscillation de la masse du gyroscope du résonateur primaire, comme représenté à la figure 2.9 de la page 31. La mesure de la vitesse de rotation est déterminée par le résonateur secondaire du gyroscope dans une direction perpendiculaire au mouvement de la masse oscillante. Ceci ne permet pas de réduire la consommation électrique du système, ce qui est un inconvénient. Plusieurs perturbations sont également constatées entre l'activation d'oscillation de la masse et la détection du mouvement de la masse pour réguler l'amplitude d'oscillation, ce qui constitue un autre inconvénient.

On peut encore citer le document intitulé "Force to rebalance control of HRG and suppression of its errors on the basis of FPGA" de Xu Wang, Wenqi Wu, Bing Luo, Zhen Fang, Yun Li et Qingan Jiang, publié le 16 décembre 2011 dans Sensors 2011 (ISSN 1424-8220). Ce document décrit un nouveau concept d'adaptation de force pour un résonateur gyroscopique hémisphérique sur la base d'un FPGA. Le système décrit prévoit une oscillation forcée de la masse par un oscillateur du type VCO sur la base de signaux cos(ω·t) et sin(ω·t). Le système détecte le mouvement du résonateur secondaire, qui est défini comme l'électrode sud pour alimenter le résonateur primaire, qui est défini comme l'électrode ouest. Ainsi cela permet d'annuler la vibration sur le primaire. Dans cette boucle d'asservissement, la phase et l'amplitude sont asservies pour fournir exactement l'énergie nécessaire pour annuler le mouvement du secondaire.

Un inconvénient de ce système est qu'il est utilisé un oscillateur du type VCO. Cela ne permet pas de réduire la consommation électrique générale du système pour l'asservissement de la phase et de l'amplitude d'oscillation. De plus, il est utilisé l'information, qui provient du secondaire pour faire osciller le résonateur primaire. Cela complique la réalisation, ainsi que la précision d'asservissement de la phase et de l'amplitude d'oscillation. Le primaire est dépendant du secondaire, ce qui constitue un autre inconvénient.

Il est également connu de la demande de brevet US 2011/0005315 A1 un circuit électronique d'entraînement d'un gyroscope MEMS, qui contrôle le mouvement de la masse oscillante en utilisant un schéma d'asservissement à filtre de Kalman, ayant pour entrée la dérivée temporelle (digitalisée) de la charge des électrodes de détection.

### RESUME DE L'INVENTION

L'invention a donc pour but de pallier aux inconvénients de l'état de la technique susmentionné en fournissant un circuit électronique d'entraînement d'un dispositif à résonateur du type MEMS peu complexe et qui permet de minimiser la consommation électrique tout en réduisant le temps de démarrage du circuit électronique pour l'entretien d'oscillation du résonateur.

A cet effet, l'invention concerne un circuit électronique d'entraînement d'un dispositif à résonateur du type MEMS, qui comprend les caractéristiques définies dans la revendication indépendante 1.

Des formes particulières d'exécution du circuit électronique d'entraînement d'un dispositif à résonateur du type MEMS sont définies dans les revendications dépendantes 2 à 12.

Un avantage du circuit électronique d'entraînement d'un dispositif à résonateur du type MEMS réside dans le fait que l'énergie transmise au résonateur primaire du dispositif est maximisée, ce qui permet d'éviter d'utiliser une tension d'alimentation élevée. Le circuit électronique d'entraînement est également moins complexe que tout circuit électronique de l'état de la technique pour remplir les mêmes fonctions d'entretien de l'oscillation de la masse à une amplitude d'oscillation déterminée.

Avantageusement, le temps de démarrage du circuit électronique pour la mise en oscillation du résonateur primaire du dispositif est fortement réduit. A ce titre un générateur d'entraînement peut générer un signal d'activation au démarrage, qui n'a pas besoin d'être totalement synchronisé à la fréquence propre du ressort lié à la masse oscillante. Il peut donc aisément être utilisé comme générateur d'entraînement initial un simple oscillateur du type RC facile à réaliser avec un nombre restreint de composants électroniques. Un tel circuit électronique d'entraînement du résonateur primaire peut être intégré sur une surface d'intégration réduite. De plus, le schéma d'excitation du circuit électronique est également très simplifié.

A cet effet, l'invention concerne également un procédé de mise en action d'un circuit électronique d'entraînement d'un dispositif à résonateur du type MEMS, qui comprend les caractéristiques définies dans la revendication indépendante 13.

Une étape particulière du procédé est définie dans la revendication dépendante 14.

### BREVE DESCRIPTION DES FIGURES

Les buts, avantages et caractéristiques du circuit électronique d'entraînement d'un dispositif à résonateur du type MEMS, et du procédé de mise en action du circuit électronique, apparaîtront mieux dans la description suivante sur la base d'au moins une forme d'exécution non limitative illustrée par les dessins sur lesquels :
la figure 1 représente de manière simplifiée les composants du circuit électronique d'entraînement relié au résonateur du type MEMS selon l'invention,
la figure 2 représente une forme d'exécution d'un convertisseur courant-tension du circuit électronique d'entraînement pour la détection du mouvement de la masse du résonateur selon l'invention,
la figure 3 représente une forme d'exécution d'une unité de décision du circuit électronique d'entraînement pour la fourniture d'un signal d'activation à un élément d'activation de la masse du résonateur selon l'invention, et
les figures 4a à 4d représentent des graphes des signaux relatifs à la détection du mouvement de la masse du résonateur et à l'activation de la masse oscillante dans le circuit électronique d'entraînement dans le cas d'une énergie d'activation maximale à fournir ou à extraire et dans le cas d'une énergie d'activation intermédiaire à fournir ou à extraire selon l'invention.

### DESCRIPTION DETAILLEE DE L'INVENTION

Dans la description suivante, tous les composants électroniques du circuit électronique d'entraînement directement relié au résonateur du dispositif à résonateur, qui sont bien connus de l'homme du métier dans ce domaine technique ne seront relatés que de manière simplifiée. Préférentiellement le dispositif à résonateur est un gyroscope à capteur ou résonateur du type MEMS à haut facteur de qualité. Les fonctions de base du circuit électronique d'entraînement sont d'une part de faire osciller la masse du résonateur primaire, c'est-à-dire de la faire osciller dans une direction déterminée, et de contrôler l'amplitude de l'oscillation mécanique de la masse.

La figure 1 représente une forme d'exécution du circuit électronique d'entraînement 1 relié au résonateur 2 du type MEMS. Le circuit électronique d'entraînement 1 permet d'une part d'activer le résonateur 2 par l'intermédiaire d'un élément d'activation C_{act} et d'autre part de détecter le mouvement d'une masse m du résonateur 2 par l'intermédiaire d'un élément de détection C_{det}. Les éléments d'activation C_{act} et de détection C_{det} peuvent être considérés généralement comme faisant partie des composants du résonateur 2, mais ils peuvent aussi être considérés comme faisant partie du circuit électronique d'entraînement 1 du résonateur 2. En fonction de la mesure ou détection du mouvement de la masse m, une adaptation d'amplitude d'oscillation de la masse est effectuée dans une boucle d'asservissement du circuit électronique.

Le gyroscope du type MEMS est donc composé en plus du circuit électronique d'entraînement 1 décrit en détail ci-après, d'un résonateur 2, qui est défini comme un résonateur primaire, et d'un résonateur secondaire pour la mesure d'une vitesse de rotation du gyroscope selon une direction ou selon un axe déterminé. Cependant dans la présente invention, il n'est considéré de préférence que le résonateur primaire 2 comme représenté à la figure 1, car le résonateur secondaire n'influence pas le résonateur primaire ou dans une moindre mesure.

La rotation du résonateur du type MEMS peut injecter une énergie vibratoire dans la masse mobile. Cependant, comme le système oscillant du résonateur MEMS possède une fréquence de résonance propre, et qu'il est très sélectif, l'énergie fournie en dehors de cette bande de fréquence est fortement atténuée. De ce fait, l'oscillation induite dans la masse du résonateur MEMS est très faible. La masse totale du gyroscope considéré est supposée tourner autour de 2000 degrés/seconde, c'est-à-dire à 5 tours/seconde. Cela correspond à une fréquence de 5 Hz, alors que le résonateur MEMS considéré possède une bande passante autour de 20 kHz. Comme les fréquences en jeu sont considérablement éloignées l'une de l'autre, il est possible de ne considérer que le résonateur primaire pour le circuit électronique d'entraînement 1.

Un tel résonateur 2 peut donc comprendre une masse sismique m, qui est reliée à un ressort k, à un élément d'amortissement d en parallèle du ressort, à un élément de détection C_{det} et à un élément d'activation C_{act}. En appliquant une tension sur l'élément d'activation C_{act}, cela engendre une force électrostatique d'attraction et pour fournir une énergie électromécanique à l'ensemble sismique constitué de la masse m avec le ressort k et l'élément d'amortissement d. Ainsi il est possible de mettre en mouvement ladite masse m par une succession d'impulsions de tension fournies à l'élément d'activation.

De préférence, l'élément d'activation est un condensateur d'activation C_{act} et l'élément de détection est un condensateur de détection Cadet, qui peut être placé en parallèle du condensateur d'activation C_{act}. Les électrodes de ces deux condensateurs sont disposées en parallèle, mais sans contact direct. La valeur capacitive du condensateur d'activation C_{act} ou du condensateur de détection C_{det} donne une image de la position de la masse sismique m et permet d'effectuer un asservissement dans le circuit électronique d'entraînement par l'intermédiaire du condensateur de détection C_{det}. La vitesse primaire ou la force dans une direction est ainsi mesurée par le condensateur de détection C_{det}. Par contre, la masse est mise en mouvement par l'intermédiaire du condensateur d'activation C_{act}.

Le circuit électronique d'entraînement 1 permet de maintenir une amplitude définie d'oscillation d'une masse sismique m. La fréquence d'oscillation de la masse m est dépendante du facteur k du ressort, dont une extrémité est reliée à une structure fixe du gyroscope. La masse sismique m est de préférence reliée à la borne de terre comme la structure fixe. Ceci garantit de bien découpler les deux condensateurs utilisés pour l'activation de l'oscillation de la masse m retenue par le ressort k et pour la détection du mouvement de la masse. De préférence, il est opéré une lecture de la dérivée du mouvement de la masse sismique m.

Ce circuit électronique 1 d'entraînement ou d'asservissement avec le résonateur primaire 2 fait partie normalement d'un gyroscope MEMS à haut facteur de qualité pour la mesure de la vitesse de rotation angulaire comme celle d'un disque. Dans ce gyroscope, il est utilisé également le résonateur secondaire avec un autre condensateur pour la mesure de la vitesse de direction perpendiculaire à la vitesse mesurée du résonateur primaire. Cette vitesse de direction perpendiculaire est obtenue en fonction de la vitesse de rotation angulaire de la masse du gyroscope à déterminer selon un axe de mesure.

Le circuit électronique d'entraînement 1 comprend un moyen de conversion 3 relié à une électrode fixe du condensateur de détection C_{det}. L'autre électrode du condensateur est reliée à la masse en mouvement, qui peut être reliée à la borne de terre. La distance entre les électrodes du condensateur de détection varie avec le déplacement de la masse. Le moyen de conversion permet d'effectuer une lecture par voie électronique analogique du mouvement de la masse m. Une variation de la distance I entre l'électrode fixée sur la masse et l'électrode dans une position fixe permet d'effectuer la mesure de la vitesse de mouvement de la masse. La valeur capacitive du condensateur de détection est donnée par C_{det} = ε·S/I, où la distance I est variable dans le temps, alors que la surface S des électrodes en regard l'une de l'autre reste constante.

Le moyen de conversion 3 est de préférence un convertisseur courant-tension 3, qui fournit en sortie un signal de dérivée der du mouvement de la masse sur la base d'un courant de détection I_{det} provenant du condensateur de détection C_{det}. Ce signal de dérivée der est généralement un signal sinusoïdal en tension, dont la fréquence correspond à la fréquence d'oscillation de la masse en mouvement. Ce signal de dérivée der en sortie du convertisseur 3 est fourni dans une première branche à une unité de décision 7.

L'amplitude du signal de dérivée der doit être comparée normalement à une référence ou consigne d'amplitude ref déterminée. Cette comparaison est effectuée par un moyen de comparaison dans l'unité de décision 7 ou par un moyen de comparaison, qui est disposé dans une seconde branche entre la sortie du convertisseur 3 et l'unité de décision 7. En fonction du niveau d'amplitude du signal de dérivée der par rapport à une référence ou consigne d'amplitude ref, l'unité de décision 7 est susceptible de fournir un signal d'activation drive à une électrode fixe du condensateur d'activation C_{act}. Ce signal d'activation drive est adapté pour entretenir l'oscillation de la masse sismique à une amplitude souhaitée.

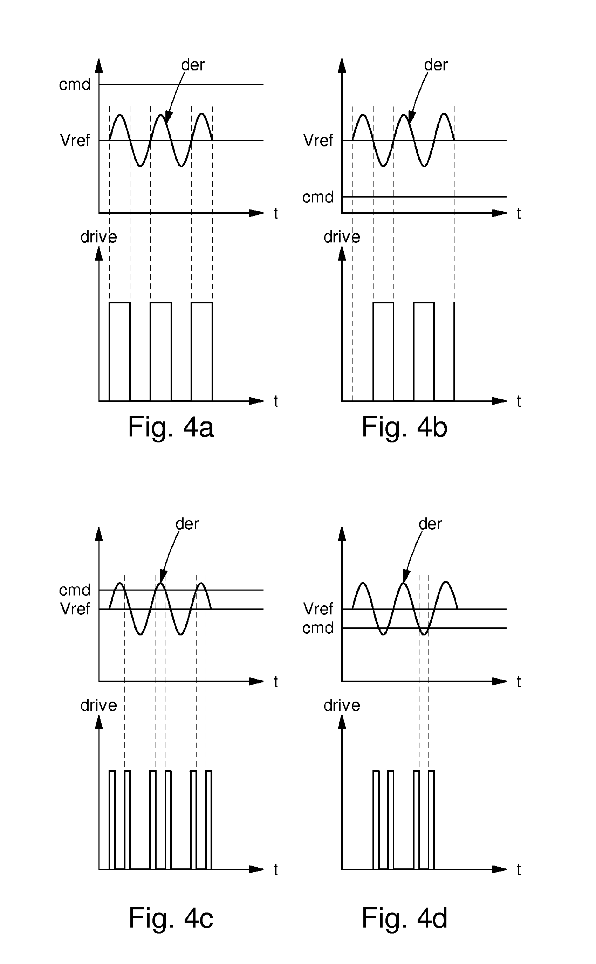

Généralement l'unité de décision 7 agit comme une unité logique avec une fourniture de signaux impulsionnels d'activation drive de la masse m comme des signaux numériques. L'électrode fixe du condensateur d'activation peut recevoir des impulsions de tension positive pour l'activation selon cette forme d'exécution, mais des impulsions de tension négative peuvent aussi être utilisées pour l'activation. Ces signaux impulsionnels sont décrits ci-après en référence aux figures 4a à 4d et sont définis entre une valeur basse de tension, par exemple à 0 V d'une source de tension d'alimentation non représentée, et une valeur haute de tension, par exemple la tension fournie directement par la source de tension d'alimentation, qui peut être d'une valeur située entre 1.65 V et 3.3 V.

De préférence, le circuit électronique d'entraînement 1 comprend un moyen de comparaison particulier en dehors de l'unité de décision 7 pour comparer l'amplitude du signal de dérivée der avec une consigne ou référence d'amplitude ref. Pour ce faire, le signal de dérivée der est fourni à l'entrée d'un détecteur d'amplitude 4. Ce détecteur d'amplitude peut être un détecteur de pics traditionnel pour détecter par exemple le point le plus élevé du signal de dérivée der ou un élément redresseur suivi par un filtre passe-bas. Un comparateur 5 en sortie du détecteur d'amplitude 4 compare l'amplitude du signal de dérivée der avec la consigne d'amplitude ref. L'amplitude du signal de dérivée est fournie à l'entrée négative du comparateur 5, alors que la consigne d'amplitude ref est fournie à l'entrée positive du comparateur 5. Si l'amplitude du signal de dérivée est plus basse que la consigne d'amplitude, cela signifie qu'il faut augmenter l'amplitude d'oscillation de la masse, alors que dans le cas contraire, il faut diminuer l'amplitude d'oscillation de la masse en mouvement.

Le signal de comparaison en sortie du comparateur 5 peut encore passer par un filtre de correction 6 pour fournir un signal de commande du niveau d'amplitude cmd à l'unité de décision 7. Ce signal de commande cmd est supérieur au point le plus élevé du signal de dérivée der s'il est nécessaire d'augmenter rapidement l'amplitude d'oscillation de la masse en mouvement. Par contre ce signal de commande cmd est inférieur au point le plus bas du signal de dérivée der s'il est nécessaire de diminuer rapidement l'amplitude d'oscillation de la masse en mouvement comme expliqué ci-après en référence aux figures 4a et 4b. Les impulsions de tension drive fournies par l'unité de décision 7 au condensateur d'activation C_{act} sont donc dépendantes de la comparaison entre le signal de comparaison cmd fourni dans la seconde branche et le signal de dérivée der fourni dans la première branche.

Le circuit électronique d'entraînement 1 comprend encore un générateur de démarrage 9, qui est utilisé dans une phase initiale de mise en fonction du circuit électronique 1 du dispositif à résonateur. Ce générateur 9 fournit un signal de démarrage au condensateur d'activation C_{act} à travers un multiplexeur 8 commandé par un signal de commutation Sc. L'autre entrée du multiplexeur reçoit le signal d'activation drive de l'unité de décision 7, mais dans une phase initiale de démarrage, le signal de commutation Sc permet de relier le générateur de démarrage 9 au condensateur d'activation C_{act}.

La fréquence du signal de démarrage du générateur 9 pour activer la masse m du résonateur 2 n'est pas synchronisée à la fréquence propre du ressort. Cela fait que la combinaison du signal de démarrage d'activation et du signal d'oscillation passe par une amplitude minimale (zéro) et une amplitude maximale due au déphasage des signaux. Cela n'a pas une grande importance dans le cas présent, car il peut être par exemple utilisé un simple oscillateur du type RC dans le générateur 9 pour la génération du signal d'activation au démarrage. Cependant il pourrait aussi être utilisé un autre type d'oscillateur sans rétroaction sur l'amplitude d'oscillation.

Après un temps déterminé par un compteur non représenté, le multiplexeur 8 est commandé par le signal de commutation Sc pour relier l'unité de décision 7 au condensateur d'activation C_{act} pour fermer la boucle d'asservissement d'amplitude d'oscillation sur la base d'une valeur de consigne fournie ref. Il est nécessaire d'avoir un signal de dérivée der d'un niveau suffisant pour pouvoir utiliser ce signal dans la boucle d'asservissement, c'est pourquoi il est nécessaire d'imposer au départ un signal d'activation de démarrage par le générateur de démarrage 9.

A la figure 2, il est représenté une forme d'exécution du convertisseur courant-tension 3 utilisé pour la détection du mouvement de la masse oscillante et la fourniture du signal de dérivée du mouvement der. Une des électrodes du condensateur de détection C_{det}, qui est l'électrode fixe, est reliée à une entrée négative d'un amplificateur 13, par exemple un amplificateur opérationnel. L'autre électrode du condensateur, qui est l'électrode mobile reliée à la masse sismique m, est de préférence reliée à la borne de terre de la source de tension d'alimentation. Une tension de référence Vref est fournie à une entrée positive de l'amplificateur 3. Une résistance R relie l'entrée négative de l'amplificateur 3 et la sortie de l'amplificateur, qui fournit le signal de dérivée der. Le signal de dérivée der est ainsi un signal de tension de forme sinusoïdale par rapport à la tension de référence Vref, qui définit la tension en mode commun de ce signal de dérivée der. Ce signal est sinusoïdal également par le fait que le résonateur MEMS a un haut facteur de qualité avec une fréquence hautement sélective.

Il est à noter que le courant de détection I_{det} est proportionnel à la vitesse de la masse sismique Ce courant de détection I_{det}, qui provient de l'électrode fixe du condensateur de détection C_{det}, est défini par la formule I = dQ/dt = d(C·V)/dt = C·dV/dt + V·dC/dt = V·dC/dt étant donné que C·dV/dt dans ce cas devient proche de 0. Ainsi V·dC/dt représente le signal de dérivée der, car la valeur capacitive du condensateur C_{det} varie comme la distance x entre les électrodes varie avec le mouvement de la masse sismique m. La distance au repos entre les électrodes est x₀ et x = x₀ + Δx avec Δx très petit par rapport à x₀, et cela représente bien l'image de la dérivée donc la vitesse linéaire.

La figure 3 représente une forme d'exécution de l'unité de décision 7, qui représente une unité logique pour la fourniture de signaux impulsionnels drive comme des signaux numériques. L'unité de décision 7 comprend tout d'abord deux amplificateurs 71 et 72, qui sont des comparateurs rapides. La sortie de chaque amplificateur de comparaison est soit à un niveau haut représentatif d'un état "1", soit à un niveau bas représentatif d'un état "0" d'un signal numérique. Le premier amplificateur 71 reçoit à une entrée négative la tension de référence Vref et à une entrée positive le signal de dérivée der. Le second amplificateur 72 reçoit à une entrée négative le signal de commande d'amplitude cmd et à une entrée positive le signal de dérivée der. Quand le signal de dérivée der est supérieur à la tension de référence Vref et au signal de commande cmd, la sortie des amplificateurs 71, 72 est à l'état "1 ". Quand le signal de dérivée der est inférieur à la tension de référence Vref et au signal de commande cmd, la sortie des amplificateurs 71, 72 est à l'état "0".

L'unité de décision 7 comprend encore une première porte ET 75, qui reçoit à une première entrée le signal de sortie du premier amplificateur 71 et à une seconde entrée le signal de sortie du second amplificateur 72 inversé par un premier inverseur 73. L'unité de décision 7 comprend encore une seconde porte ET 76, qui reçoit à une première entrée le signal de sortie du second amplificateur 72 et à une seconde entrée le signal de sortie du premier amplificateur 71 inversé par un second inverseur 74. Le signal de sortie de la première porte ET 75 est fourni à une première entrée d'une porte OU 77, alors que le signal de sortie de la seconde porte ET 76 est fourni à une seconde entrée de la porte OU 77. Le signal d'activation préliminaire en sortie de la porte OU 77 peut encore passer par un élément élévateur de tension 78 pour fournir le signal d'activation drive en sortie de l'unité de décision 7, qui est un signal à impulsions, tel un signal numérique. Les impulsions du signal d'activation sont agencées en fonction du niveau du signal de commande cmd, du niveau de la tension de référence Vref en comparaison avec le signal de dérivée der.

Il est à noter que le signal d'activation préliminaire, qui est fourni à la sortie de la porte OU 77 peut être directement utilisé pour activer le condensateur d'activation. Cependant le signal obtenu en sortie de la porte OU 77 doit être de préférence décalé de niveau par l'élément élévateur de tension 78 en fonction du niveau de la tension d'alimentation la plus élevée du circuit électronique intégré pour maximiser l'énergie fournie au résonateur MEMS.

Pour bien comprendre le fonctionnement du circuit électronique, il est fait référence aux figures 4a à 4d. Sur ces figures 4a à 4d, il est représenté différents signaux partiellement dans le temps depuis la détection du mouvement de la masse du résonateur par le condensateur de détection jusqu'à l'activation du condensateur d'activation. Les figures 4a à 4d montrent différentes phases pour adapter l'amplitude d'oscillation de la masse avant de maintenir l'oscillation de la masse à une amplitude déterminée. Il est principalement représenté la forme du signal de commande cmd, du signal de dérivée der référencé par rapport à la tension de référence Vref et le signal d'activation drive dans différents états d'ajustement de l'amplitude d'oscillation de la masse oscillante.

Il est clair que le signal de commande cmd change tout au long de l'ajustement de l'amplitude d'oscillation définie par le signal de dérivée der normalement jusqu'à une stabilité du système avec une amplitude ajustée de l'oscillation. Une fois l'amplitude d'oscillation ajustée sur la base de la consigne d'amplitude ref souhaitée et programmée, normalement le signal de commande cmd se trouve au niveau de la tension de référence Vref. Dans ces conditions, il ne subsiste pratiquement plus que de simples impulsions sous forme de Dirac, qui sont fournies dans le signal d'activation drive pour tenir compte également du facteur d'amortissement de l'élément d'amortissement du ressort. Cela permet de maintenir l'oscillation de la masse à une amplitude désirée, tout en réduisant considérablement la consommation électrique du circuit électronique.

Sur la figure 4a, il est représenté le cas où l'amplitude d'oscillation de la masse est bien en-dessous de la consigne d'amplitude souhaitée. Dans ces conditions, le signal de commande cmd se trouve au-dessus du point le plus haut du signal de dérivée der, et donc au-dessus de la tension de référence Vref. Sur la base des amplificateurs et portes de l'unité de décision, le signal d'activation drive fournit des impulsions rectangulaires de tension, quand le signal de dérivée der se trouve au-dessus de la tension de référence. Chaque impulsion du signal drive est générée avec une largeur correspondant au demi-cycle en phase positive du signal de dérivée der par rapport à une tension définie en mode commun, qui est la tension de référence Vref. Le demi-cycle en phase positive correspond à l'alternance positive du signal de dérivée der.

Avec le signal de commande cmd au-dessus du signal de dérivée der, cela signifie que l'amplitude d'oscillation de la masse doit être augmentée. Pour fournir de l'énergie au résonateur selon la figure 4a, il doit y avoir une dérivée positive du mouvement de la masse dans le temps. La force générée au résonateur primaire est exprimée par la formule F_{act} = d(E_{act})/dl = ε·S·V²/(2·I²), où V est la tension aux bornes du condensateur d'activation, S est la surface en regard des électrodes du condensateur, ε est la constante diélectrique du condensateur et I, qui est variable, est la distance séparant les électrodes du condensateur. L'énergie d'activation est ainsi exprimée par la formule E_{act} = C·V²/2 = f F_{act}·(dl/dt)·dt = f F_{act}·dl. Cette énergie devient optimale quand V est maximum pendant que le signal de dérivée der est positif dans le demi-cycle au-dessus de la tension de référence Vref et 0 quand le signal de dérivée der est négatif dans le demi-cycle au-dessous de la tension de référence Vref.

Sur la figure 4b, il est représenté le cas inverse où l'amplitude d'oscillation de la masse est bien en-dessus de la consigne d'amplitude souhaitée. Dans ces conditions, le signal de commande cmd se trouve au-dessous du point le plus bas du signal de dérivée der, et donc au-dessous de la tension de référence Vref. Sur la base des amplificateurs et portes de l'unité de décision, le signal d'activation drive fournit des impulsions rectangulaires de tension, quand le signal de dérivée der se trouve au-dessous de la tension de référence. Chaque impulsion du signal drive est générée avec une largeur correspondant au demi-cycle en phase négative du signal de dérivée der par rapport à la tension de référence Vref. Le demi-cycle en phase négative correspond à l'alternance négative du signal de dérivée der.

Avec le signal de commande cmd au-dessous du signal de dérivée der, cela signifie que l'amplitude d'oscillation de la masse doit être diminuée. Pour extraire de l'énergie au résonateur selon la figure 4b, il doit y avoir une dérivée négative du mouvement de la masse dans le temps. Cette énergie devient optimale quand V est maximum pendant que le signal de dérivée der est négatif dans le demi-cycle au-dessous de la tension de référence Vref et 0 quand le signal de dérivée der est positif dans le demi-cycle au-dessus de la tension de référence Vref.

Sur la figure 4c, il est représenté le cas où l'amplitude d'oscillation de la masse est légèrement en-dessous de la consigne d'amplitude souhaitée dans une phase intermédiaire. Dans ces conditions, le signal de commande cmd se trouve entre le point le plus haut du signal de dérivée der et la tension de référence Vref. Sur la base des amplificateurs et portes de l'unité de décision, le signal d'activation drive fournit deux impulsions rectangulaires de tension, quand le signal de dérivée der se trouve dans le demi-cycle positif au-dessus de la tension de référence Vref, mais en-dessous du signal de commande cmd. Quand le signal de dérivée der est au-dessus du signal de commande cmd, le signal d'activation drive redevient égal à 0. La largeur des deux impulsions pour chaque demi-cycle positif du signal de dérivée der diminue plus le signal de commande cmd s'approche de la tension de référence Vref correspondant à la stabilité d'oscillation du système.

Sur la figure 4d, il est représenté le cas inverse de la figure 4c, où l'amplitude d'oscillation de la masse est légèrement en-dessus de la consigne d'amplitude souhaitée dans une phase intermédiaire. Dans ces conditions, le signal de commande cmd se trouve entre le point le plus bas du signal de dérivée der et la tension de référence Vref. Sur la base des amplificateurs et portes de l'unité de décision, le signal d'activation drive fournit deux impulsions rectangulaires de tension, quand le signal de dérivée der se trouve dans le demi-cycle négatif au-dessous de la tension de référence Vref, mais en-dessus du signal de commande cmd. Quand le signal de dérivée der est au-dessous du signal de commande cmd, le signal d'activation drive redevient égal à 0. La largeur des deux impulsions pour chaque demi-cycle négatif du signal de dérivée der diminue plus le signal de commande cmd s'approche de la tension de référence Vref correspondant à la stabilité d'oscillation du système.

Comme représenté sur les figures 4a à 4d, le signal d'activation drive comprend une succession d'impulsions rectangulaires agencées soit pour augmenter l'amplitude d'oscillation de la masse, soit pour diminuer l'amplitude d'oscillation de ladite masse. Ce signal d'activation drive peut être considéré comme un signal numérique fourni par une unité de décision, qui est une unité logique. Cela se différencie de tout signal d'activation des circuits électroniques d'entraînement de gyroscopes de l'état de la technique, qui utilise préférentiellement des signaux sous forme sinusoïdale pour adapter l'amplitude d'oscillation de la masse. Une fois que l'amplitude d'oscillation se trouve au niveau de la consigne d'amplitude souhaitée, les impulsions du signal d'activation drive sont de largeur minimale. Ces impulsions du signal d'activation drive sont toujours présentes pour pallier à l'amortissement du ressort lié à la masse oscillante.

Généralement pour le procédé de mise en action du circuit électronique d'entraînement du résonateur du dispositif à résonateur, il doit tout d'abord être débuté par la fourniture d'un signal de démarrage de forme sinusoïdale. Ce signal de démarrage est fourni par le générateur de démarrage comme expliqué ci-devant. Après une durée définie de la mise en oscillation de la masse par ce signal de démarrage, uniquement le signal d'activation drive est fourni au condensateur d'activation pour adapter l'amplitude d'oscillation de la masse. La boucle d'asservissement de la présente invention permet de réduire considérablement la consommation électrique tout en garantissant un temps de démarrage réduit et l'utilisation d'une tension d'alimentation selon la technologie d'intégration utilisée. Le schéma d'excitation du circuit électronique est également simplifié.

Pour le circuit électronique d'entraînement, il peut aussi être envisagé d'asservir la phase du signal de dérivée. Une mesure de la phase peut ainsi être effectuée par rapport à une référence de phase d'un signal numérique, dont la fréquence peut être choisie de manière à optimiser l'efficacité énergétique du système. Cela signifie, qu'il peut être recherché de minimiser l'énergie consommée par le circuit électronique, et de déphaser le signal d'activation drive pour obtenir l'asservissement de la phase.

Il est encore à noter que le résonateur avec le circuit électronique d'entraînement décrits ci-devant sont prévus normalement pour la mesure d'une vitesse angulaire d'un gyroscope selon une direction ou un axe défini. Cependant il est tout à fait envisageable d'utiliser la conception du circuit électronique avec une ou plusieurs masses pour une mesure de vitesse angulaire selon un, deux ou trois axes avec un gyroscope du type MEMS à haut facteur de qualité.

A partir de la description qui vient d'être faite, plusieurs variantes du circuit électronique d'entraînement du résonateur du dispositif à résonateur, et le procédé de mise en action du circuit électronique, peuvent être conçues par l'homme du métier sans sortir du cadre de l'invention définie par les revendications. L'élément de détection peut aussi être une jauge de contrainte. Dans ces conditions, une valeur résistive variable traversée par un courant déterminé permet de définir le mouvement de ladite masse dans le circuit électronique.

## Revendications

1. Circuit électronique d'entraînement (1) d'un gyroscope à résonateur du type MEMS, le circuit électronique étant relié à au moins un résonateur (2) du dispositif à résonateur, le résonateur comprenant une masse (m) reliée à une structure du dispositif par un ressort (k) et un élément d'amortissement (d), un élément d'activation (C_{act}) configuré pour mettre en mouvement dans une direction la masse sur la base d'un signal d'activation (drive), qui est fourni par le circuit électronique, et un élément de détection (C_{det}) configuré pour détecter le mouvement de la masse traité dans le circuit électronique et pour adapter au moins un niveau d'amplitude d'oscillation de la masse en mouvement, **caractérisé en ce que** le circuit électronique d'entraînement (1) comprend un moyen de conversion (3) relié à l'élément de détection (C_{det}) configuré pour fournir un signal de dérivée mathématique (der) du déplacement de la masse en oscillation, un moyen de comparaison (4, 5, 6) configuré pour comparer un niveau d'amplitude du signal de dérivée mathématique (der) et une référence d'amplitude définie (ref), et pour fournir un signal de commande (cmd) de niveau d'amplitude, et une unité de décision (7), qui est reliée au moyen de conversion (3) et au moyen de comparaison (4, 5, 6), et qui est configurée pour fournir un signal d'activation (drive) de forme numérique à l'élément d'activation (C_{act}), ledit signal d'activation étant composé d'une succession d'impulsions rectangulaires agencées et déterminées, sur la base du signal de dérivée mathématique (der) et du signal de commande (cmd), pour augmenter ou diminuer ou maintenir l'amplitude d'oscillation de la masse en mouvement en fonction de la référence d'amplitude définie (ref).

2. Circuit électronique d'entraînement (1) selon la revendication 1, **caractérisé en ce que** le moyen de conversion (3) est un convertisseur courant-tension (3) recevant un courant de détection (I_{det}) de l'élément de détection (C_{det}) et fournissant un signal de dérivée mathématique (der), qui est un signal sinusoïdal en tension.

3. Circuit électronique d'entraînement (1) selon la revendication 2, pour lequel l'élément de détection (C_{det}) est un condensateur de détection, dont une première électrode est reliée à la masse en mouvement et une seconde électrode est reliée au convertisseur courant-tension, **caractérisé en ce que** le convertisseur courant-tension (3) comprend un amplificateur (13), dont une entrée négative est reliée à la seconde électrode du condensateur de détection et une entrée positive reçoit une tension de référence (Vref), une résistance (R) étant placée entre l'entrée négative et une sortie de l'amplificateur (13), qui fournit le signal de dérivée mathématique (der) sous forme sinusoïdale référencée par rapport à la tension de référence (Vref) avec une alternance positive au-dessus de la tension de référence et une alternance négative au-dessous de la tension de référence.

4. Circuit électronique d'entraînement (1) selon la revendication 1, **caractérisé en ce qu'**une sortie du moyen de conversion (3), qui fournit le signal de dérivée mathématique (der), est directement reliée à l'unité de décision dans une première branche, et **en ce que** le moyen de comparaison (4, 5, 6) est disposé dans une seconde branche entre la sortie du moyen de conversion (3) et l'unité de décision (7).

5. Circuit électronique d'entraînement (1) selon la revendication 4, **caractérisé en ce que** le moyen de comparaison comprend un détecteur d'amplitude (4), qui reçoit le signal de dérivée mathématique (der), et un comparateur (5) en sortie du détecteur d'amplitude (4) pour comparer l'amplitude du signal de dérivée mathématique (der) avec la référence d'amplitude définie (ref) et fournir un signal de commande (cmd) de niveau dépendant de la comparaison entre l'amplitude du signal de dérivée mathématique et la référence d'amplitude définie (ref).

6. Circuit électronique d'entraînement (1) selon la revendication 5, **caractérisé en ce que** la sortie du détecteur d'amplitude (4) est reliée à une entrée négative du comparateur (5), alors qu'une entrée positive du comparateur (5) reçoit la référence d'amplitude définie (ref), de manière que le signal de commande (cmd) fourni par le moyen de comparaison est d'un niveau du côté d'une alternance positive du signal de dérivée mathématique (der) sous forme sinusoïdale, si l'amplitude d'oscillation de la masse doit être augmentée, ou d'un niveau du côté d'une alternance négative du signal de dérivée mathématique (der), si l'amplitude d'oscillation de la masse doit être diminuée.

7. Circuit électronique d'entraînement (1) selon la revendication 5, **caractérisé en ce que** le détecteur d'amplitude (4) est un détecteur de pics ou un élément redresseur suivi par un filtre passe-bas.

8. Circuit électronique d'entraînement (1) selon la revendication 5, **caractérisé en ce que** le moyen de comparaison comprend en outre un filtre de correction (6) relié à la sortie du comparateur (5) pour fournir le signal de commande du niveau d'amplitude (cmd) à l'unité de décision (7).

9. Circuit électronique d'entraînement (1) selon la revendication 1, **caractérisé en ce que** l'unité de décision (7) est configurée pour fournir un signal d'activation numérique (drive) avec des impulsions rectangulaires disposées en fonction de la comparaison entre une tension de référence (Vref), le signal de dérivée mathématique (der) de forme sinusoïdale référencée par rapport à la tension de référence (Vref), et le signal de commande (cmd) du niveau d'amplitude, si le niveau du signal de commande (cmd) est au-dessus de la tension de référence (Vref), une ou deux impulsions rectangulaires étant générées par l'unité de décision (7) pour chaque alternance positive du signal de dérivée mathématique, alors que si le niveau du signal de commande (cmd) est au-dessous de la tension de référence (Vref), une ou deux impulsions rectangulaires étant générées par l'unité de décision (7) pour chaque alternance négative du signal de dérivée mathématique.

10. Circuit électronique d'entraînement (1) selon la revendication 9, **caractérisé en ce que** l'unité de décision (7), qui est une unité logique, comprend un premier amplificateur d'entrée (71), qui reçoit à une entrée négative une tension de référence (Vref) et à une entrée positive le signal de dérivée mathématique (der) référencé par rapport à la tension de référence (Vref), un second amplificateur d'entrée (72), qui reçoit à une entrée négative le signal de commande (cmd) de niveau d'amplitude et à une entrée positive le signal de dérivée mathématique (der), la sortie des premier et second amplificateurs (71, 72) étant à un état "1", si le signal de dérivée mathématique est supérieur à la tension de référence et au signal de commande, et à un état "0", si le signal de dérivée mathématique est inférieur à la tension de référence et au signal de commande, **en ce que** l'unité de décision (7) comprend encore une première porte ET (75), qui reçoit à une première entrée le signal de sortie du premier amplificateur (71) et à une seconde entrée le signal de sortie du second amplificateur (72) inversé par un premier inverseur (73), et une seconde porte ET (76), qui reçoit à une première entrée le signal de sortie du second amplificateur (72) et à une seconde entrée le signal de sortie du premier amplificateur (71) inversé par un second inverseur (74), et **en ce que** l'unité de décision (7) comprend encore une porte OU (77) pour recevoir à une première entrée le signal de sortie de la première porte ET (75) et à une seconde entrée le signal de sortie de la seconde porte ET (76), la sortie de la porte OU étant reliée à un élément élévateur de tension (78) pour fournir le signal d'activation (drive) en sortie de l'unité de décision (7).

11. Circuit électronique d'entraînement (1) selon la revendication 1, **caractérisé en ce qu'**il comprend un générateur de démarrage (9) relié à une première entrée d'un multiplexeur (8), une seconde entrée du multiplexeur étant reliée à la sortie de l'unité de décision (7), ledit multiplexeur (8) étant contrôlé par un signal de commutation (Sc) de manière à relier le générateur de démarrage (9) à l'élément d'activation (C_{act}) dans une phase initiale de mise en fonction du circuit électronique pour initier l'oscillation de la masse (m), et à relier l'unité de décision (7) dans une phase subséquente après la mise en fonction du circuit électronique.

12. Circuit électronique d'entraînement (1) selon la revendication 11, **caractérisé en ce que** le générateur de démarrage (9) est un oscillateur du type RC pour fournir un signal de démarrage oscillant à l'élément d'activation (C_{act}), qui est un condensateur d'activation, dont une première électrode est reliée à la masse en mouvement et une seconde électrode est reliée à la sortie du multiplexeur (8).

13. Procédé de mise en action du circuit électronique d'entraînement (1) du dispositif à résonateur du type MEMS, selon l'une des revendications précédentes, **caractérisé en ce que** le procédé comprend les étapes de :
- détecter le mouvement de la masse oscillante et fournir un signal de dérivée mathématique (der) par un convertisseur courant-tension (3) relié à l'élément de détection du résonateur (2),
- comparer le niveau d'amplitude du signal de dérivée mathématique (der) par rapport à une référence d'amplitude (ref) pour fournir un signal de commande (cmd) du niveau d'amplitude,
- commander l'unité de décision (7), qui est une unité logique, pour fournir le signal d'activation (drive) de forme numérique à l'élément d'activation (C_{act}), où ledit signal d'activation est composé d'une succession d'impulsions rectangulaires agencées et déterminées sur la base du signal de dérivée mathématique (der) et du signal de commande (cmd) pour augmenter ou diminuer ou maintenir l'amplitude d'oscillation de la masse en mouvement en fonction de la référence d'amplitude définie (ref), et
- répéter les étapes précédentes dans le circuit électronique, jusqu'à ce que l'amplitude d'oscillation de la masse en mouvement soit adaptée en fonction de la référence d'amplitude définie (ref).

14. Procédé de mise en action du circuit électronique d'entraînement (1) du dispositif à résonateur du type MEMS, selon la revendication 13, **caractérisé en ce que** dans une phase initiale de mise en fonction du circuit électronique (1), un signal de démarrage oscillant d'un générateur de démarrage (9) est fourni à l'élément d'activation (C_{act}) pour initier l'oscillation de la masse (m), et **en ce que** dans une phase subséquente, l'élément d'activation est activé par le signal d'activation (drive) de l'unité de décision (7).

## Patentansprüche

1. Elektronische Schaltung (1) zum Antreiben eines Resonator-Gyroskops des MEMS-Typs, wobei die elektronische Schaltung mit wenigstens einem Resonator (2) der Resonatorvorrichtung verbunden ist, wobei der Resonator umfasst: eine Masse (m), die mit einer Struktur der Vorrichtung über eine Feder (k) und ein Dämpfungselement (d) verbunden ist, ein Aktivierungselement (C_{act}), das konfiguriert ist, die Masse anhand eines Aktivierungssignals (drive), das von der elektronischen Schaltung geliefert wird, in einer Richtung in Bewegung zu setzen, und ein Detektionselement (C_{det}), das konfiguriert ist, die Bewegung der Masse, die in der elektronischen Schaltung verarbeitet wird, zu detektieren und wenigstens einen Pegel der Oszillationsamplitude der in Bewegung befindlichen Masse anzupassen, **dadurch gekennzeichnet, dass** die elektronische Antriebsschaltung (1) umfasst: ein Umsetzungsmittel (3), das mit dem Detektionselement (C_{det}) verbunden ist und konfiguriert ist, ein Signal der mathematischen Ableitung (der) der Verlagerung der oszillierenden Masse zu liefern, ein Vergleichsmittel (4, 5, 6), das konfiguriert ist, einen Amplitudenpegel des Signals (der) der mathematischen Ableitung mit einer definierten Referenzamplitude (ref) zu vergleichen und ein Amplitudenpegel-Steuersignal (cmd) zu liefern, und eine Entscheidungseinheit (7), die mit dem Umsetzungsmittel (3) und mit dem Vergleichsmittel (4, 5, 6) verbunden ist und konfiguriert ist, ein Aktivierungssignal (drive) in digitaler Form an das Aktivierungselement (C_{act}) zu liefern, wobei das Aktivierungssignal aus einer Folge von Rechteckimpulsen gebildet ist, die auf der Basis des Signals (der) der mathematischen Ableitung und des Steuersignals (cmd) angeordnet und dazu bestimmt sind, die Oszillationsamplitude der in Bewegung befindlichen Masse als Funktion der definierten Referenzamplitude (ref) zu erhöhen oder zu erniedrigen oder beizubehalten.

2. Elektronische Antriebsschaltung (1) nach Anspruch 1, **dadurch gekennzeichnet, dass** das Umsetzungsmittel (3) ein Strom/Spannung-Umsetzer (3) ist, der von dem Detektionselement (C_{det}) einen Detektionsstrom (I_{det}) empfängt und ein Signal (der) der mathematischen Ableitung, das ein sinusförmiges Spannungssignal ist, liefert.

3. Elektronische Antriebsschaltung (1) nach Anspruch 2, wobei das Detektionselement (C_{det}) ein Detektionskondensator ist, dessen erste Elektrode mit der in Bewegung befindlichen Masse verbunden ist und dessen zweite Elektrode mit dem Strom/Spannung-Umsetzer verbunden ist, **dadurch gekennzeichnet, dass** der Strom/Spannung-Umsetzer (3) einen Verstärker (13) umfasst, wovon ein negativer Eingang mit der zweiten Elektrode des Detektionskondensators verbunden ist und wovon ein positiver Eingang eine Referenzspannung (Vref) empfängt, wobei zwischen den negativen Eingang und einen Ausgang des Verstärkers (13) ein Widerstand (R) geschaltet ist, der das Signal (der) der mathematischen Ableitung als Sinusform liefert, die auf die Referenzspannung (Vref) bezogen ist und eine positive Halbperiode oberhalb der Referenzspannung und eine negative Halbperiode unterhalb der Referenzspannung besitzt.

4. Elektronische Antriebsschaltung (1) nach Anspruch 1, **dadurch gekennzeichnet, dass** ein Ausgang des Umsetzungsmittels (3), der das Signal (der) der mathematischen Ableitung liefert, in einem ersten Zweig direkt mit der Entscheidungseinheit verbunden ist und dass das Vergleichsmittel (4, 5, 6) in einem zweiten Zweig zwischen dem Ausgang des Umsetzungsmittels (3) und der Entscheidungseinheit (7) angeordnet ist.

5. Elektronische Antriebsschaltung (1) nach Anspruch 4, **dadurch gekennzeichnet, dass** das Vergleichsmittel umfasst: einen Amplitudendetektor (4), der das Signal (der) der mathematischen Ableitung empfängt, und einen Komparator (5) am Ausgang des Amplitudendetektors (4), um die Amplitude des Signals (der) der mathematischen Ableitung mit der definierten Referenzamplitude (ref) zu vergleichen und um einen Steuersignal (cmd) mit einem Pegel, der von dem Vergleich zwischen der Amplitude des Signals der mathematischen Ableitung und der definierten Referenzamplitude (ref) abhängt, zu liefern.

6. Elektronische Antriebsschaltung (1) nach Anspruch 5, **dadurch gekennzeichnet, dass** der Ausgang des Amplitudendetektors (4) mit einem negativen Eingang des Komparators (5) verbunden ist, während ein positiver Eingang des Komparators (5) die definierte Referenzamplitude (ref) empfängt, derart, dass das Steuersignal (cmd), das von dem Vergleichsmittel geliefert wird, einen Pegel auf Seiten einer positiven Halbperiode des Signals (der) der mathematischen Ableitung in Sinusform hat, falls die Oszillationsamplitude der Masse erhöht werden soll, oder einen Pegel auf Seiten einer negativen Halbperiode des Signals (der) der mathematischen Ableitung hat, falls die Oszillationsamplitude der Masse erniedrigt werden soll.

7. Elektronische Antriebsschaltung (1) nach Anspruch 5, **dadurch gekennzeichnet, dass** der Amplitudendetektor (4) ein Spitzendetektor oder ein Gleichrichterelement, gefolgt von einem Tiefpassfilter, ist.

8. Elektronische Antriebsschaltung (1) nach Anspruch 5, **dadurch gekennzeichnet, dass** das Vergleichsmittel außerdem ein Korrekturfilter (6) umfasst, das mit dem Ausgang des Komparators (5) verbunden ist, um das Steuersignal (cmd) für den Amplitudenpegel an die Entscheidungseinheit (7) zu liefern.

9. Elektronische Antriebsschaltung (1) nach Anspruch 1, **dadurch gekennzeichnet, dass** die Entscheidungseinheit (7) konfiguriert ist, ein digitales Aktivierungssignal (drive) mit Rechteckimpulsen, die als Funktion des Vergleichs zwischen einer Referenzspannung (Vref), dem Signal (der) der mathematischen Ableitung in Sinusform, die auf die Referenzspannung (Vref) bezogen ist, und des Steuersignals (cmd) für den Amplitudenpegel angeordnet sind, zu liefern, wobei dann, wenn der Pegel des Steuersignals (cmd) über der Referenzspannung (Vref) liegt, ein oder zwei Rechteckimpulse durch die Entscheidungseinheit (7) für jede positive Halbperiode des Signals der mathematischen Ableitung erzeugt werden, und wobei dann, wenn der Pegel des Steuersignals (cmd) unter der Referenzspannung (Vref) liegt, ein oder zwei Rechteckimpulse von der Entscheidungseinheit (7) für jede negative Halbperiode des Signals der mathematischen Ableitung erzeugt werden.

10. Elektronische Antriebsschaltung (1) nach Anspruch 9, **dadurch gekennzeichnet, dass** die Entscheidungseinheit (7), die eine Logikeinheit ist, umfasst: einen ersten Eingangsverstärker (71), der an einem negativen Eingang eine Referenzspannung (Vref) empfängt und an einem positiven Eingang das Signal (der) der mathematischen Ableitung, das auf die Referenzspannung (Vref) bezogen ist, empfängt, und einen zweiten Eingangsverstärker (72), der an einem negativen Eingang das Steuersignal (cmd) für den Amplitudenpegel empfängt und an einem positiven Eingang das Signal (der) der mathematischen Ableitung empfängt, wobei der Ausgang des ersten und des zweiten Verstärkers (71, 72) in einem Zustand "1" ist, falls das Signal der mathematischen Ableitung größer als die Referenzspannung und als das Steuersignal ist, und in einem Zustand "0" ist, falls das Signal der mathematischen Ableitung kleiner als die Referenzspannung und als das Steuersignal ist, dass die Entscheidungseinheit (7) außerdem umfasst: ein erstes UND-Gatter (75), das an einem ersten Eingang das Ausgangssignal des ersten Verstärkers (71) empfängt und an einem zweiten Eingang das durch einen ersten Inverter (73) invertierte Ausgangssignal des zweiten Verstärkers (72) empfängt, und ein zweites UND-Gatter (76), das an einem ersten Eingang das Ausgangssignal des zweiten Verstärkers (72) empfängt und an einem zweiten Eingang das durch einen zweiten Inverter (74) invertierte Ausgangssignal des ersten Verstärkers (71) empfängt, und dass die Entscheidungseinheit (7) außerdem ein ODER-Gatter (77) umfasst, um an einem ersten Eingang das Ausgangssignal des ersten UND-Gatters (75) und an einem zweiten Eingang das Ausgangssignal des zweiten UND-Gatters (76) zu empfangen, wobei der Ausgang des ODER-Gatters mit einem Spannungserhöhungselement (78) verbunden ist, um am Ausgang der Entscheidungseinheit (7) das Aktivierungssignal (drive) zu liefern.

11. Elektronische Antriebsschaltung (1) nach Anspruch 1, **dadurch gekennzeichnet, dass** sie einen Startergenerator (9) umfasst, der mit einem ersten Eingang eines Multiplexers (8) verbunden ist, wobei ein zweiter Eingang des Multiplexers mit dem Ausgang der Entscheidungseinheit (7) verbunden ist, wobei der Multiplexer (8) durch ein Kommutationssignal (Sc) in der Weise gesteuert wird, dass er den Startergenerator (9) mit dem Aktivierungselement (C_{act}) in einer Anfangsphase der Inbetriebnahme der elektronischen Schaltung verbindet, um die Oszillationen der Masse (m) einzuleiten, und die Entscheidungseinheit (7) in einer nachfolgenden Phase nach der Inbetriebnahme der elektronischen Schaltung verbindet.

12. Elektronische Antriebsschaltung (1) nach Anspruch 11, **dadurch gekennzeichnet, dass** der Startergenerator (9) ein Oszillator vom RC-Typ ist, um ein oszillierendes Startsignal an das Aktivierungselement (C_{act}) zu liefern, das ein Aktivierungskondensator ist, wovon eine erste Elektrode mit der in Bewegung befindlichen Masse verbunden ist und eine zweite Elektrode mit dem Ausgang des Multiplexers (8) verbunden ist.

13. Verfahren zum Inbetriebnehmen der elektronischen Antriebsschaltung (1) der Resonatorvorrichtung des MEMS-Typs nach einem der vorhergehenden Ansprüche, **dadurch gekennzeichnet, dass** das Verfahren die folgenden Schritte umfasst:
- Detektieren der Bewegung der oszillierenden Masse und Liefern eines Signals (der) der mathematischen Ableitung durch einen Strom/Spannung-Umsetzer (3), der mit dem Detektionselement des Resonators (2) verbunden ist,
- Vergleichen des Amplitudenpegels des Signals (der) der mathematischen Ableitung mit einer Referenzamplitude (ref), um ein Steuersignal (cmd) für den Amplitudenpegel zu liefern,
- Steuern der Entscheidungseinheit (7), die eine Logikeinheit ist, damit sie das Aktivierungssignal (drive) in digitaler Form an das Aktivierungselement (C_{act}) liefert, wobei das Aktivierungssignal aus einer Folge von Rechteckimpulsen gebildet ist, die auf der Basis des Signals (der) der mathematischen Ableitung und des Steuersignals (cmd) angeordnet und dazu bestimmt sind, die Oszillationsamplitude der in Bewegung befindlichen Masse als Funktion der definierten Referenzamplitude (ref) zu erhöhen oder zu erniedrigen oder beizubehalten, und
- Wiederholen der vorhergehenden Schritte in der elektronischen Schaltung, bis die Oszillationsamplitude der in Bewegung befindlichen Masse als Funktion der definierten Referenzamplitude (ref) angepasst ist.

14. Verfahren zum Inbetriebnehmen der elektronischen Antriebsschaltung (1) der Resonatorvorrichtung des MEMS-Typs nach Anspruch 13, **dadurch gekennzeichnet, dass** in einer Anfangsphase der Inbetriebnahme der elektronischen Schaltung (1) ein oszillierendes Startsignal eines Startergenerators (9) an das Aktivierungselement (C_{act}) geliefert wird, um die Oszillation der Masse (m) einzuleiten, und dass in einer nachfolgenden Phase das Aktivierungselement durch das Aktivierungssignal (drive) der Entscheidungseinheit (7) aktiviert wird.

## Claims

1. Electronic drive circuit (1) for a MEMS type resonator gyroscope, the electronic drive circuit being connected to at least one resonator (2) of the resonator gyroscope, the resonator including a mass (m) connected to a structure of the gyroscope by a spring (k) and a damping element (d), an actuation element (C_{act}) configured for setting the mass in motion in one direction on the basis of an actuation signal (drive), which is supplied by the electronic circuit, and a detection element (C_{det}) configured for detecting the motion of the mass processed in the electronic circuit and to adapt at least one oscillation amplitude level of the moving mass,
**characterized in that** the electronic drive circuit (1) includes a conversion means (3) connected to the detection element (C_{det}) configured to supply a mathematical derivative signal (der) of the motion of the mass in oscillation, a comparison means (4, 5, 6) configured for comparing an amplitude level of the mathematical derivative signal (der) and a defined reference amplitude (ref), and for supplying an amplitude level control signal (cmd), and a decision unit (7), which is connected to the conversion means (3) and to the comparison means (4, 5, 6), and which is configured to supply an actuation signal (drive) in digital form to the actuation element (C_{act}), said actuation signal being formed of a series of rectangular pulses arranged and determined, on the basis of the mathematical derivative signal (der) and of the control signal (cmd), to increase or decrease or maintain the oscillation amplitude of the moving mass as a function of the defined reference amplitude (ref).

2. Electronic drive circuit (1) according to claim 1, **characterized in that** the conversion means (3) is a current-voltage converter (3) receiving a detection current (I_{det}) from the detection element (C_{det}) and supplying a mathematical derivative signal (der), which is a sinusoidal voltage signal.

3. Electronic drive circuit (1) according to claim 2, wherein the detection element (C_{det}) is a detection capacitor, whose first electrode is connected to the moving mass and whose second electrode is connected to the current-voltage converter, **characterized in that** the current-voltage converter (3) includes an amplifier (13), a negative input of which is connected to the second electrode of the detection capacitor and a positive electrode receives a reference voltage (Vref), a resistor (R) being placed between the negative input and an output of the amplifier (13), which supplies the mathematical derivative signal (der) in sinusoidal form referenced relative to the reference voltage (Vref) with a positive alternation above the reference voltage and a negative alternation below the reference voltage.

4. Electronic drive circuit (1) according to claim 1, **characterized in that** an output of the conversion means (3), which supplies the mathematical derivative signal (der), is immediately connected to the decision unit in a first branch, and **in that** the comparison means (4, 5, 6) is arranged in a second branch between the output of the conversion means (3) and the decision unit (7).

5. Electronic drive circuit (1) according to claim 4, **characterized in that** the comparison means includes an amplitude detector (4), which receives the mathematical derivative signal (der), and a comparator (5) at the output of the amplitude detector (4) for comparing the amplitude of the mathematical derivative signal (der) to the defined reference amplitude (ref) and supplying a level control signal (cmd) dependent on the comparison between the derivative signal amplitude and the defined reference amplitude (ref).

6. Electronic drive circuit (1) according to claim 5, **characterized in that** the output of the amplitude detector (4) is connected to a negative input of the comparator (5), whereas a positive input of the comparator (5) receives the defined reference amplitude (ref), so that the level of the control signal (cmd) supplied by the comparison means is on a positive alternation of the mathematical derivative signal (der) in sinusoidal form, if the mass oscillation amplitude has to be increased, or in a negative alternation of the mathematical derivative signal (der), if the mass oscillation amplitude has to be decreased.

7. Electronic drive circuit (1) according to claim 5, **characterized in that** the amplitude detector (4) is a peak detector or a rectifier element followed by a low pass filter.

8. Electronic drive circuit (1) according to claim 5, **characterized in that** the comparison means further includes a correction filter (6) connected to the output of the comparator (5) for supplying the amplitude level control signal (cmd) to the decision unit (7).

9. Electronic drive circuit (1) according to claim 1, **characterized in that** the decision unit (7) is configured to supply a digital actuation signal (drive) with rectangular pulses arranged as a function of the comparison between a reference voltage (Vref), the sinusoidal mathematical derivative signal (der) referenced with respect to the reference voltage (Vref), and the amplitude level control signal (cmd), if the level of the control signal (cmd) is above the reference voltage (Vref), one or two rectangular pulses are generated by the decision unit (7) for each positive alternation of the mathematical derivative signal, whereas if the level of the control signal (cmd) is below the reference voltage (Vref), one or two rectangular pulses are generated by the decision unit (7) for each negative alternation of the mathematical derivative signal.

10. Electronic drive circuit (1) according to claim 9, **characterized in that** the decision unit (7), which is a logic unit, includes a first input amplifier (71), which receives a reference voltage (Vref) at a negative input and the mathematical derivative signal (der) referenced with respect to the reference voltage (Vref) at a positive input, a second input amplifier (72), which receives the amplitude level control signal (cmd) at a negative input and the mathematical derivative signal (der) at a positive input, the output of the first and second amplifiers (71, 72) being in a 1 state, if the mathematical derivative signal is higher than the reference voltage and than the control signal, and in a 0 state if the mathematical derivative signal is lower than the reference voltage and than the control signal, **in that** the decision unit (7) also includes a first AND gate (75), which receives the output signal from the first amplifier (71) at a first input and the output signal from the second amplifier (72) inverted by a first inverter (73) at a second input, and a second AND gate (76) which receives the output signal from the second amplifier (72) at a first input, and the output signal from the first amplifier (71) inverted by a second inverter (74) at a second input, and **in that** the decision unit (7) further includes an OR gate (77) for receiving the output signal from the first AND gate (75) at a first input and the output signal from the second AND gate (76) at a second input, the output of the OR gate being connected to a voltage booster element (78) for supplying the actuation signal (drive) at the output of the decision unit (7).

11. Electronic drive circuit (1) according to claim 1, **characterized in that** the circuit includes a start generator (9) connected to a first input of a multiplexer (8), a second input of the multiplexer being connected to the output of the decision unit (7), said multiplexer (8) being controlled by a switching signal (Sc) so as to connect the start generator (9) to the actuation element (C_{act}) in an initial actuation phase of the electronic circuit for setting the mass (m) in oscillation, and to connect the decision unit (7) in a subsequent phase after actuation of the electronic circuit.

12. Electronic drive circuit (1) according to claim 11, **characterized in that** the start generator (9) is an RC type oscillator for supplying an oscillating start signal to the actuation element (C_{act}), which is an actuation capacitor, a first electrode of which is connected to the moving mass and a second electrode is connected to the output of the multiplexer (8).

13. Method for actuating an electronic drive circuit (1) of the MEMS type resonator gyroscope according to any of the preceding claims, **characterized in that** the method includes the steps of:
- detecting motion of the oscillating mass and supplying a mathematical derivative signal (der) via a current-voltage converter (3) connected to the detection element of the resonator (2),
- comparing the amplitude level of the mathematical derivative signal (der) relative to a reference amplitude (ref) to supply an amplitude level control signal (cmd),
- controlling the decision unit (7), which is a logic unit, to supply the actuation signal (drive) in digital form to the actuation element (C_{act}), wherein said actuation signal comprises a series of rectangular pulses arranged and determined on the basis of the mathematical derivative signal (der) and of the control signal (cmd) to increase or decrease or maintain the oscillation amplitude of the moving mass as a function of the defined reference amplitude (ref), and
- repeating the preceding steps in the electronic circuit, until the oscillation amplitude of the moving mass is adapted as a function of the defined reference amplitude (ref).

14. Method for actuating the electronic drive circuit (1) of the MEMS type resonator gyroscope according to claim 13, **characterized in that** in an initial actuation phase of the electronic circuit (1), an oscillating start signal from a start generator (9) is supplied to the actuation element (C_{act}) to initiate the oscillation of the mass (m), and **in that** in a subsequent phase, the actuation element is actuated by the actuation signal (drive) from the decision unit (7).
